# EUROPÄISCHE PATENTSCHRIFT

(11) **EP 2 534 011 B1**
(45) Veröffentlichungstag und Bekanntmachung des Hinweises auf die Patenterteilung: **14.05.2014**
(21) Anmeldenummer: 11702948.8
(22) Anmeldetag: 20.01.2011
(51) Int. Cl.: B60R 16/023

(54) **FAHRZEUG-SENSOR-KNOTEN**
VEHICLE SENSOR NODES
CAPTEUR NOEUDS POUR UN VÉHICULE

(30) Priorität: 22.12.2010 DE 102010063984; 11.02.2010 DE 102010001827
(43) Veröffentlichungstag der Anmeldung: 19.12.2012
(73) Patentinhaber: Continental Teves AG & Co. oHG, 60488 Frankfurt (DE)
(72) Erfinder: GÜNTHNER, Stefan, 60489 Frankfurt (DE); KOLBE, Alexander, 64846 Groß-Zimmern (DE); SCHMID, Bernhard, 61169 Friedberg (DE); SIMON, Otmar, 35415 Pohlheim/Holzheim (DE); STÄHLIN, Ulrich, 65670 Eschborn (DE)
(86) Internationale Anmeldenummer: PCT/EP2011/050774
(87) Internationale Veröffentlichungsnummer: WO 2011/098333

(56) Entgegenhaltungen:
- EP-A1- 1 386 802
- DE-A1- 10 238 936

## Beschreibung

Die Erfindung betrifft ein Sensorsystem gemäß Oberbegriff von Anspruch 1.

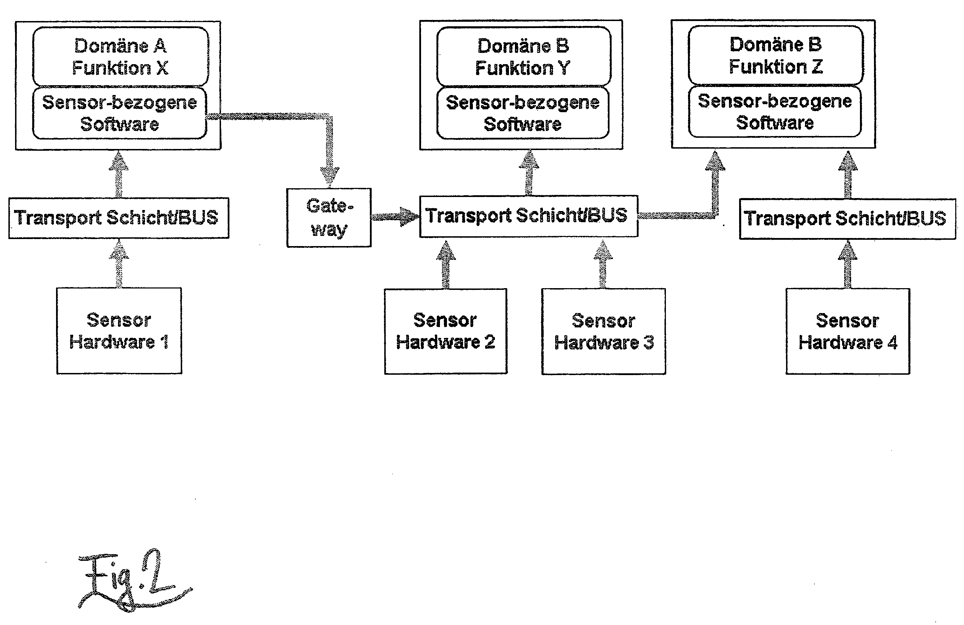

In heutigen, aus dem Stand der Technik bekannten, Fahrzeugarchitekturen sind Sensoren bzw. Sensorelemente primär Funktionen bzw. Funktionseinrichtungen zugeordnet. Sensorsignale können aber auch von sekundären Funktionen verwendet werden, indem sie entweder über Schnittstellen bzw. Gateways weitergereicht werden, was vor allem bei sicherheitsrelevanten primären Funktionen der Fall ist, oder indem sie direkt zugänglich sind. Ein Beispiel eines solchen Sensorsystems gemäß Stand der Technik ist anhand der Fig. 2 veranschaulicht.

Sensorsysteme sind auch in EP 1386802 und in DE 10238936 offenbart.

Der Erfindung liegt die Aufgabe zu Grunde ein Sensorsystem vorzuschlagen, welches eine effiziente Struktur aufweist, insbesondere hinsichtlich des Entwicklungsaufwands für ein solches Sensorsystem, und/oder welches eine verbesserte Ausfallsicherheit und/oder eine höhere Genauigkeit bietet.

Diese Aufgabe wird erfindungsgemäß gelöst durch das Sensorsystem gemäß Anspruch 1.

Das Sensorsystem ist vorzugsweise als Teil eines Kraftfahrzeugregelungssystems ausgebildet und zumindest eine der Funktionseinrichtungen ist als Fahrdynamikregelungsfunktion und/oder Kraftfahrzeugsicherheitsfunktion und/oder Kraftfahrzeuginsassenkomfortfunktion ausgebildet, wobei insbesondere diese wenigstens eine Funktion zumindest teilweise als Programm ausgebildet ist.

Die Signalverarbeitungsfunktionen der Signalverarbeitungseinrichtung den Funktionseinrichtungen gebündelt und/oder in definierter, gemeinsamer Weise bereitgestellt werden.

Unter dem Begriff "verbunden" wird bevorzugt eine hardwaremäßige und/oder eine softwaremäßige Verbindung verstanden, also insbesondere eine Kommunikation von Programmen oder Programmteilen über definierte Schnittstellen.

Das Sensorsystem umfasst bevorzugt Sensorelemente mit mindestens drei, insbesondere wenigstens fünf, unterschiedlichen primären Messgrößen und/oder wenigstens drei Sensorelemente, insbesondere zumindest fünf Sensorelemente, die auf unterschiedlichen Messprinzipien beruhen bzw. unterschiedliche Messprinzipien nutzen.

Die Signalverarbeitungseinrichtung ist vorzugsweise so ausgebildet, dass sie wenigstens die drei folgenden Signalverarbeitungsfunktionen umfasst, zumindest eine Fehlerbehandlung, welche als Fail-Safe-Funktion oder Fail-Silent-Funktion ausgebildet ist, wenigstens eine Filterung und mindestens eine Berechnung einer abgeleiteten Messgröße.

Das Sensorsystem ist zweckmäßigerweise so ausgebildet, dass die Sensorelemente und die Einrichtungen, also zumindest die Signalverarbeitungseinrichtung und insbesondere zusätzlich die Schnittstelleneinrichtung und die Funktionseinrichtung, auf einer Platine und/oder in einer gemeinsam gehäusten elektronischen Komponente integriert sind, also beispielsweise in der elektronischen Kontrolleinheit eines Kraftfahrzeugregelungssystems.

Die Sensorelemente dieses Sensorsystems gemeinsam und/oder jeweils mit der Signalverarbeitungseinrichtung verbunden sind. Dabei ist insbesondere keines der Sensorelemente mit einer oder mehreren Funktionseinrichtungen direkt verbunden und/oder kommuniziert direkt mit einer oder mehreren Funktionseinrichtungen.

Die Signalverarbeitungseinrichtung so ausgebildet ist, dass sie zusätzlich eine Informationsqualitätsbewertungsfunktion aufweist, welche eine Information über die Zuverlässigkeit und/oder Genauigkeit und/oder Verfügbarkeit einer oder mehrerer oder jeder einzelnen der abgeleiteten und/oder primären Messgröße/n bereitstellt.

Unter der Information über die Genauigkeit wird bevorzugt ein Attribut zu einer ersten oder einer definierten weiteren Messgröße verstanden, wobei diese erste Messgröße zumindest teilweise redundant vorliegt. Das Sensorsystem weist dafür zwei oder mehr, insbesondere unterschiedliche, Messpfade zur Bereitstellung dieser Messgröße auf, wobei jeder Messpfad zumindest ein Sensorelement und wenigstens eine Signalverarbeitungsfunktion umfasst. Jedem dieser Messpfade ist besonders bevorzugt eine Messgenauigkeit zugeordnet, welche über Modellbildung und/oder Testmessungen und/oder eine Spezifikation definiert ist. Die der ersten Messgröße durch die Informationsqualitätsbewertungsfunktion zugeordnete Messgenauigkeit ergibt sich dabei aus den Messgenauigkeiten der zwei oder mehr Messpfade, welche diese erste Messgröße zumindest teilweise redundant bereitstellen, wobei die Messgenauigkeit dieser ersten Messgröße dabei ganz besonders bevorzugt der besten/größten Messgenauigkeit eines Messpfades aus der Menge der Messgenauigkeiten der aktuell verfügbaren Messpfade für diese erste Messgröße entspricht. Unter dem Begriff Messgenauigkeit wird zweckmäßigerweise eine Messpräzision bzw. (relativ geringe) Messabweichung bzw. Messfehler verstanden.

Unter der Information über die Zuverlässigkeit wird bevorzugt ein durch die Informationsqualitätsbewertungsfunktion zugeordnetes Attribut zu einer ersten oder einer definierten weiteren Messgröße verstanden, wobei diese erste Messgröße zumindest teilweise redundant vorliegt. Das Sensorsystem weist dafür zwei oder mehr, insbesondere unterschiedliche, Messpfade zur Bereitstellung dieser Messgröße auf, wobei jeder Messpfad zumindest ein Sensorelement und wenigstens eine Signalverarbeitungsfunktion umfasst. Die aktuellen Messwerte dieser Messpfade werden plausibilisiert bzw. miteinander verglichen und dabei wird insbesondere eine Information darüber generiert, mit welcher Sicherheit die erste Messgröße aktuell bereitgestellt werden kann, in Abhängigkeit bzw. unter Berücksichtigung der absoluten und/oder relativen Abweichungen der aktuellen Messwerte unterschiedlicher Messpfade der ersten Messgröße. Bezüglich der Information über die Zuverlässigkeit der ersten Messgröße wird besonders bevorzugt berücksichtigt und verstanden, in wie weit die Funktionseinrichtungen die bereitgestellten Messwerte verwenden können bzw. welchen Sicherheitsanforderungen der aktuelle Wert dieser ersten Messgröße genügt. Der Vergleich bzw. die Plausibilisierung der Messwerte der unterschiedlichen Messpfade wird beispielsweise anhand einer Tabelle mit definierten Messgrößenintervallen durchgeführt.

Unter der Information über die Verfügbarkeit wird bevorzugt ein durch die Informationsqualitätsbewertungsfunktion zugeordnetes Attribut zu einer ersten oder einer definierten weiteren Messgröße verstanden, wobei diese erste Messgröße zumindest teilweise redundant vorliegt. Das Sensorsystem weist dafür zwei oder mehr, insbesondere unterschiedliche, Messpfade zur Bereitstellung dieser Messgröße auf, wobei jeder Messpfad zumindest ein Sensorelement und wenigstens eine Signalverarbeitungsfunktion umfasst. Die Verfügbarkeit ist zweckmäßigerweise eine Information darüber, wie lange ein Signal bzw. eine Messgröße noch verfügbar ist, also eine Zeitinformation. Zur Gewinnung der Verfügbarkeit wird bevorzugt der Fall berücksichtigt bzw. bewertet, dass ein erster Messpfad, insbesondere der Messpfad mit der besten Genauigkeit und/oder Zuverlässigkeit, aus der Menge der Messpfade zu der ersten Messgröße ausfallen würde oder gerade augefallen ist und wie lange mittels der anderen Messpfade diese erste Messgröße noch bereitgestellt werden kann/ könnte und damit der Ausfall des ersten Messpfades hinreichend kompensiert werden kann, unter Berücksichtigung einer definierten Mindestgenauigkeitsanforderung und einer definierten Mindestzuverlässigkeitsanforderung.

Es ist bevorzugt, dass die Informationsqualitätsbewertungsfunktion jeder Messgröße, insbesondere jedem Messwert einer Messgröße, einen oder mehrere oder alle der folgenden Informationen, insbesondere als definierte Variable bzw. Parameter, zuordnet: eine Genauigkeitsinformation und/oder eine Zuverlässigkeitsinformation und/oder eine Verfügbarkeitsinformation. Dabei wird diese wenigstens eine zusätzliche Information bzw. dieser wenigstens eine zusätzliche Parameter mit der Messgröße bzw. jedem Messwert einer Messgröße, an zumindest eine der Funktionseinrichtungen übertragen.

Es ist zweckmäßig, dass die Signalverarbeitungseinrichtung so ausgebildet ist, dass sie zusätzlich eine Kalibrierungsfunktion umfasst, mit welcher die Kalibrierung eines Sensorelements und/oder dessen Signalverarbeitung durchgeführt oder gestartet oder beeinflusst wird bzw. werden kann.

Die Signalverarbeitungseinrichtung umfasst vorzugsweise ein oder mehrere Programme, welche von wenigstens einem Mikroprozessor bzw. auf zumindest einem Mikroprozessorsystem abgearbeitet werden.

Es ist bevorzugt, dass die Schnittstelleneinrichtung als Bus und/oder als Schnittstellenprogramm ausgebildet ist, welches die Funktionseinrichtungen in definierter Weise mit Informationen versorgt und insbesondere einen bidirektionalen Informationsaustausch in definierter Form ermöglicht. Dabei ist die Schnittstelleneinrichtung besonders bevorzugt als Transportschicht eines Kommunikationsprotokolls ausgebildet, ganz besonders bevorzugt nach dem OSI-Schichtenmodell "open systems interconnection reference model".

Die Signalverarbeitungseinrichtung so ausgebildet ist, dass sie zumindest eine abgeleitete Messgröße sowie eine Information über die Zuverlässigkeit und/oder Genauigkeit und/oder Verfügbarkeit dieser abgeleiteten Messgröße jeder Funktionseinrichtung bereitstellt bzw. bereitstellen kann.

Es ist zweckmäßig, dass das Sensorsystem zumindest einen Drehratensensor, wenigstens einen Beschleunigungssensor, einen Lenkwinkelsensor und zumindest einen, insbesondere vier, Raddrehzahlsensoren als Sensorelemente aufweist und insbesondere zusätzlich wenigstens einen Chassis-Höhenstandssensor und/oder mindestens einen Umfeldsensor und/oder zumindest einen Positionssensor in Form eines Satellitennavigationssystems und/oder wenigstens einen optischen Geschwindigkeitssensor "Speed over ground Sensor", welcher optisch die Fahrbahn erfasst und daraus eine Fahrzeuggeschwindigkeit ermittelt.

Insbesondere zusätzlich oder alternativ vorzugsweise umfasst das Sensorsystem Sensorelemente, welche Umfelddaten bzw. Umfeldinformationen eines Kraftfahrzeugs erfassen, wie beispielsweise Abstände zu anderen Objekten, Fahrzeugen und/oder Informationen zur Mustererkennung von Objekten, und/oder dass die Sensorelemente so ausgebildet sind, dass sie beispielsweise Temperatur, Außenfeuchtigkeit oder Regen und/oder Größen des Motormanagements bzw. des Antriebs und der Antriebskraftübertragung erfassen.

Es ist bevorzugt, dass die Signalverarbeitungseinrichtung so ausgebildet ist, dass sie bei Detektion einer fehlerhaften oder nicht verfügbaren primären Messgröße oder abgeleiteten Messgröße, eine redundante primäre Messgröße oder abgeleitete Messgröße als Ersatzsignal und/oder Ersatzinformation für wenigstens eine Funktionseinrichtung bereitstellt.

Die Sensorelemente und die Signalverarbeitungseinrichtung und insbesondere zusätzlich die Schnittstelleneinrichtung, sind vorzugsweise so ausgebildet und miteinander verbunden, dass wenigstens die primären Messgrößen und die abgeleiteten Messgrößen in definierten Zeitintervallen und/oder mit definierten Mindestantwortzeiten den Funktionseinrichtungen bereitgestellt werden. Dazu umfasst wenigstens die Signalverarbeitungseinrichtung besonders bevorzugt ein echtzeitfähiges Mikroprozessorsystem mit einem echtzeitfähigen Betriebssystem oder einer echtzeitfähigen Programmstruktur.

Es ist bevorzugt, dass wenigstens zwei Sensorelemente einer Sensorelementgruppe direkt miteinander verbunden sind und nur ein erstes dieser Sensorelemente mit der Signalverarbeitungseinrichtung verbunden ist, wobei das erste Sensorelement als Master-Sensorelement in der Kommunikation mit dem wenigstens einen weiteren Sensorelement, als Slave-Sensorelement, dieser Sensorelementgruppe ausgebildet ist. Dabei ist die Sensorelementgruppe insbesondere so ausgebildet, besonders bevorzugt das Master-Sensorelement, dass bereits wenigstens eine primäre Messgröße mit zumindest einer abgeleiteten Messgröße des selben Typs verglichen wird und/oder redundante primäre Messgrößen miteinander verglichen werden, wobei diese Messgrößen insgesamt von mehreren Sensorelementen bereitgestellt werden, wobei das Resultat dieses zumindest einen Messgrößenvergleichs und/oder zumindest eine auf diese Weise plausibilisierte primäre Messgröße und/oder abgeleitete Messgröße der Signalverarbeitungseinrichtung zur Verfügung gestellt werden.

Alternativ vorzugsweise umfassen mehrere, insbesondere sämtliche, der Sensorelemente jeweils eine eigene Signalverarbeitungsschaltung und diese Sensorelemente sind miteinander verbunden und bilden ein Sensorelementnetzwerk, wobei die Sensorelemente dieses Netzwerks wenigstens Messgrößen und/oder abgeleitete Messgrößen zumindest teilweise miteinander austauschen und dass diese Sensorelemente so ausgebildet sind, dass sie zumindest Messgrößen und/oder abgeleitete Messgrößen wenigstens plausibilisieren, wobei das Sensorelementnetzwerk mit der Signalverarbeitungseinrichtung verbunden ist und wobei die Messgrößen und abgeleiteten Messgrößen der Sensorelemente des Sensorelementnetzwerks zumindest teilweise an die Signalverarbeitungseinrichtung übertragen werden, besonders bevorzugt wie wenigstens eine Information resultierend aus einer Plausibilisierung.

Die Signalverarbeitungseinrichtung umfasst zweckmäßigerweise nur einen einzigen Mikroprozessor bzw. Mikroprozessorkern und die Signalverarbeitungsfunktionen werden nur von einem einzigen Mikroprozessor bzw. Mikroprozessorkern abgearbeitet. Dies ist insbesondere dann vorteilhaft und möglich, wenn wenigstens eine Sensorelementgruppe und/oder zumindest ein Sensorelementnetzwerk bereits zumindest eine Plausibilisierung von Messgrößen und/oder abgeleiteten Messgrößen selbst durchführt, wodurch auch eine redundante Plausibilisierung bei nur einem Mikroprozessor bzw. Mikroprozessorkern in der Signalverarbeitungseinrichtung gewährleistet werden kann.

Das Sensorsystem oder die Signalverarbeitungseinrichtung wird vorzugsweise auch als Sensorknoten oder Fahrzeug-Sensor-Knoten bezeichnet.

Eine abgeleitete Messgröße bzw. deren Messsignal wird bevorzugt als Observable bezeichnet. Alternativ vorzugsweise wird unter einer Observablen eine primäre Messgröße oder eine abgeleitete Messgröße verstanden, also kann eine Observable insbesondere sowohl eine abgeleitete Messgröße als auch eine primäre Messgröße sein.

Unter einer abgeleiteten Messgröße wird vorzugsweise eine Messgröße verstanden, welche durch Berechnung und/oder Transformation aus einer anderen, insbesondere mit dieser zusammenhängenden bzw. von dieser abhängenden, Messgröße ermittelt wird.

Eine Messgröße umfasst zweckmäßigerweise jeweils mehrere Messwerte.

Die Sensorelemente einer Sensorelementgruppe messen bevorzugt die gleichen physikalischen Größen. Das Master-Sensorelement vergleicht nun seinen Messwert mit dem Messwert des wenigstens einen Slave-Sensorelements.

Alternativ vorzugsweise messen die Sensorelemente einer Sensorelementgruppe unterschiedliche physikalische Größen. Das Master-Sensorelement vergleicht nun seinen Messwert mit dem zumindest einen Messwert des wenigstens einen Slave-Sensorelements, indem mittels Modellen aus diesen Messwerten der eigene Messwert abgeleitet wird.

Folgende Varianten sind dabei zur Überwachung innerhalb einer Sensorelementgruppe bevorzugt:
Es werden Momentanwerte miteinander verglichen. Bei einer Abweichung größer als ein Schwellwert wird ein Fehler Signalisiert,
oder es werden gleitende Mittelwerte über einen gewissen Zeitraum verglichen. Bei einer Abweichung größer als ein Schwellwert wird ein Fehler signalisiert,
oder es wird der, insbesondere gleitende, Mittelwert der Abweichung gebildet. Überschreitet dieser eine Schwelle, so wird ein Fehler gemeldet.

Die Schnittstelleneinrichtung und/oder die Sensorelemente einer Sensorelementgruppe oder eines Sensorelementnetzwerks weisen bevorzugt zur Filterung wenigstens einen Tiefpass und/oder zumindest einen Medianfilter und/oder wenigstens eine Frequenztransformationseinrichtung auf.
Insbesondere weist das erfindungsgemäße Sensorsystem zumindest einen, oder je nach vorgeschlagener Ausbildung mehrere oder alle, der folgenden Vorteile auf:
- eine transparente, strukturierte Architektur. Durch die Einführung des Sensorsystems bzw. eines Sensorknotens wird die E-E-Architektur strukturierter und klarer hinsichtlich der Schnittstellen. Diese Standardisierung in Form des Sensorsystems bedeutet geringeren Entwicklungsaufwand für neue Funktionen. Außerdem werden Fehlermöglichkeiten aufgrund unklarer Signalflüsse und Signallaufzeiten vermindert.
- die Eliminierung überflüssiger Redundanzen. Während im Stand der Technik die Sensoren bzw. Sensorelemente primär jeweils Funktionen bzw. einzelnen Funktionseinrichtungen zugeordnet sind, sind die Signale auch primär für diese Funktionen erreichbar. Aber andere Funktionen können eventuell von diesen Sensorsignalen abgeschnitten sein, so dass sie zusätzliche Sensoren für dieselbe Messaufgabe benötigen.
Dies ist im erfindungsgemäßen Sensorsystem nicht mehr nötig.
- eine verbesserte Genauigkeit: Durch die Fusion mehrerer Sensorsignale besteht die Möglichkeit, die aus den Sensorsignalen eventuell abgeleiteten redundanten Observablen bzw. abgeleiteten Messgrößen gegeneinander zu vergleichen. Daraus lässt sich im Einzelfall eine genauere Messinformation ableiten.
- ein höheres Failsafe-Level bzw. eine verbesserte Fehlerbehandlung: Aus dem Vergleich von auf verschiedenem Wege gemessenen und berechneten Observablen lassen sich Ausfälle einzelner Sensoren schneller detektieren.
- eine höhere Verfügbarkeit: Ebenfalls durch die redundante Bestimmung von Observablen kann im Falle des Ausfalls eines Sensors die Sensorinformation länger den Fahrzeugfunktionen bzw. den Funktionseinrichtungen zur Verfügung gestellt werden.

Ein Verfahren zur Sensorsignalverarbeitung mittels des erfindungsgemäßen Sensorsystems sowie die Verwendung des Sensorsystems in Kraftfahrzeugen sowie ein Computerprogrammprodukt, welches die Programme des Sensorsystems umfasst, vorgesehen werden kann.

Weitere bevorzugte Ausführungsformen ergeben sich aus den Unteransprüchen und der nachfolgenden Beschreibung eines Ausführungsbeispiels an Hand von Figuren.

Es zeigen in schematischer Darstellung
- Fig. 1: ein Ausführungsbeispiel eines erfindungsgemäßen Sensorsystems, sowie
- Fig. 2: ein beispielhaftes Sensorsystem nach dem Stand der Technik.

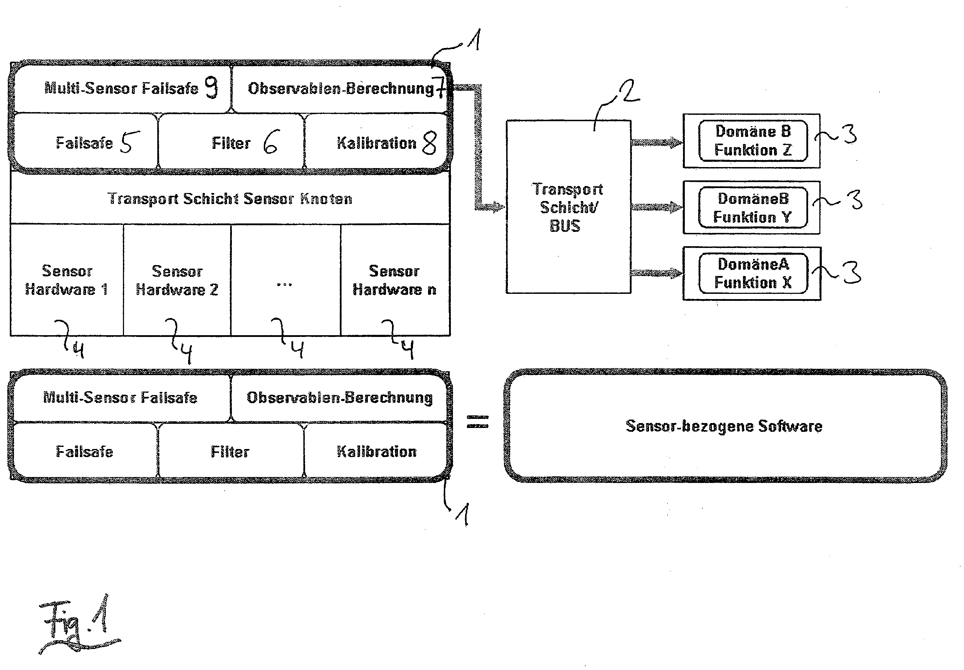

Fig. 1 zeigt ein beispielhaftes Sensorsystem. Dabei werden die Sensorelemente bzw. Sensoren 4 bezüglich ihrer Signalverarbeitung und Schnittstellen gebündelt angebunden und in das Sensorsystem eingebunden. Als Sensorelemente 4 "Sensor Hardware 1 bis n" weist das Sensorsystem beispielsweise einen Drehratensensor, einen Beschleunigungssensor, einen Lenkwinkelsensor, vier Raddrehzahlsensoren, einen Chassis-Höhenstands-Sensor sowie einen Positionssensor eines Satellitennavigationssystems (global navigation satellite systems) auf. Die Sensorelemente 4 sind mittels einer definierten Schnittstelle "Transport Schicht Sensor Knoten" mit der Schnittstelleneinrichtung 1 verbunden, wobei diese definierte Schnittstellen "Transport Schicht Sensor Knoten" beispielgemäß zumindest bezüglich der Informationsübertragung gemeinsam ausgebildet ist oder gemeinsamen Schnittstellendefinitionen genügt und wobei die physikalische Ausbildung dieser Schnittstelle für jedes Sensorelement 4 oder für Gruppen von Sensorelementen separat oder im Rahmen eines Netzwerks ausgelegt sein kann. Die Sensorelemente 4 selber sind dabei beispielsweise in einem Kraftfahrzeug verteil angeordnet, aber innerhalb des Sensorsystems so ausgewählt, dass sie Informationen für zumindest eine definierte Gruppe von Funktionseinrichtungen, beispielsweise Fahrdynamikregelungsfunktionseinrichtungen, bereitstellen.

Schnittstelleneinrichtung 1 umfasst mehrere beispielgemäß als Programme ausgebildete Signalverarbeitungsfunktionen: eine Fehlerbehandlung "Failsafe" 5, eine Fehlerbehandlung bezüglich mehrerer Sensorelemente 4 bzw. einer Gruppe von Sensorelementen 4 - "Multi-Sensor Failsafe" 9, eine Filterung "Filter" 6 von Sensorsignalen bzw. Sensorinformationen, eine Kalibrierungsfunktion "Kalibration" 8, mit welcher die Kalibrierung eines Sensorelements und/oder dessen Signalverarbeitung erfolgen kann und eine Berechnung und/oder Bereitstellung einer oder mehrerer abgeleiteter Messgrößen "Observablen-Berechnung" 7, wobei diese abgeleiteten Messgrößen bzw. Observablen beispielsweise aus unterschiedlichen Sensorsignalen bzw. mittels definierter Modellbildungen bzw. mittels definierter Berechnungen generiert werden können. So kann beispielsweise aus den Signalen der Raddrehzahlsensoren die Drehgeschwindigkeit um die Hochachse des Fahrzeugs abgeleitet werden, ebenso aus dem Gierratensensor. Diese Observablen und primären Messgrößen liefern also redundante Informationen über das Fahrzeug/Umfeld, die miteinander in der Signalverarbeitungseinrichtung bzw. im Sensorknoten verglichen werden können oder sich gegenseitig stützen können, falls auf einem Signalpfad eine Störung vorhanden ist, während der andere noch funktionsfähig ist. Aus dem Vergleich der auf verschiedenem Weg berechneten Observablen können Rückschlüsse auf die Zuverlässigkeit und Genauigkeit der Observable gezogen werden, so dass Fehlmessungen ausgefiltert werden können. Der Sensorknoten bzw. die Signalverarbeitungseinrichtung qualifiziert die Genauigkeit der Observablen und stellt die Observable zusammen mit einer Genauigkeitsangabe über eine Schnittstelleneinrichtung 2, beispielsweise die Transportschicht/der Bus des Fahrzeugs als Sensorinformation verschiedenen Funktionseinrichtungen 3 zur Verfügung, beispielsweise Funktionseinrichtungen 3 für aktive und passive Sicherheit, von Komfortsystemen und von Multimediaapplikationen.

In heutigen, aus dem Stand der Technik bekannten, Fahrzeugarchitekturen sind Sensoren bzw. Sensorelemente primär Funktionen zugeordnet, Sensorsignale können aber auch von sekundären Funktionen verwendet werden, indem sie entweder über Gateways weitergereicht werden, was vor allem bei sicherheitsrelevanten primären Funktionen der Fall ist, oder indem sie direkt zugänglich sind. Ein Beispiel gemäß dem Stand der Technik ist anhand der Fig. 2 veranschaulicht.

## Patentansprüche

1. Sensorsystem, umfassend mehrere Sensorelemente (4), die so ausgebildet sind, dass sie zumindest teilweise unterschiedliche primäre Messgrößen erfassen und zumindest teilweise unterschiedliche Messprinzipien nutzen, des Weiteren umfassend eine Signalverarbeitungseinrichtung (1), eine Schnittstelleneinrichtung (2) sowie mehrere Funktionseinrichtungen (3), wobei
die Sensorelemente (4) mit der Signalverarbeitungseinrichtung (1) verbunden sind, die so ausgelegt ist, dass sie zumindest jeweils eine der folgenden Signalverarbeitungsfunktionen für wenigstens eines der Sensorelemente (4) und/oder dessen Ausgangssignale umfasst,
eine Fehlerbehandlung (5, 9),
eine Filterung (6),
eine Berechnung und/oder Bereitstellung einer abgeleiteten Messgröße (7), wobei aus mindestens einer primären Messgröße eines oder mehrerer Sensorelemente (4) zumindest eine Messgröße abgeleitet wird,
und dass
sämtliche Funktionseinrichtungen (3) über die Schnittstelleneinrichtung (2) mit der Signalverarbeitungseinrichtung (1) verbunden sind und die Signalverarbeitungseinrichtung (1) die Signalverarbeitungsfunktionen (5, 6, 7, 8, 9) den Funktionseinrichtungen (3) bereitstellt, dadurch gekezunzeichnet, dass
die Signalverarbeitungseinrichtung (1) so ausgebildet ist, dass sie zusätzliche eine Informationsqualitätsbewertungsfunktion aufweist, welche eine Information über die Genauigkeit und die Zuverlässigkeit oder die Genauigkeit und die Verfügbarkeit oder die Genauigkeit und
die Zuverlässigkeit und die Verfügbarkeit einer oder mehrerer oder jeder einzelnen der abgeleiteten und/oder primärem Messgröße/n bereitstellt.

2. Sensorsystem nach Anspruch 1, **dadurch gekennzeichnet, dass** dieses als Teil eines Kraftfahrzeugregelungssystems ausgebildet ist und dass zumindest eine der Funktionseinrichtungen (3) als Fahrdynamikregelungsfunktion und/oder Kraftfahrzeugsicherheitsfunktion und/oder Kraftfahrzeuginsassenkomfortfunktion ausgebildet ist, wobei insbesondere diese wenigstens eine Funktion wenigstens teilweise als Programm ausgebildet ist.

3. Sensorsystem nach Anspruch 1 oder 2, **dadurch gekennzeichnet, dass** alle Sensorelemente (4) dieses Sensorsystems gemeinsam und/oder jeweils mit der Signalverarbeitungseinrichtung (1) verbunden sind.

4. Sensorsystem nach mindestens einem der Ansprüche 1 bis 3, **dadurch gekennzeichnet, dass** die Signalverarbeitungseinrichtung (1) so ausgebildet ist, dass sie zusätzlich eine Kalibrierungsfunktion (8) umfasst, mit welcher die Kalibrierung eines Sensorelements (4) und/oder dessen Signalverarbeitung durchgeführt oder gestartet oder beeinflusst wird.

5. Sensorsystem nach mindestens einem der Ansprüche 1 bis 4, **dadurch gekennzeichnet, dass** die Signalverarbeitungseinrichtung (1) ein oder mehrere Programme umfasst, welche auf wenigstens einem Mikroprozessor abgearbeitet werden.

6. Sensorsystem nach mindestens einem der Ansprüche 1 bis 5, **dadurch gekennzeichnet, dass** die Schnittstelleneinrichtung (2) als Bus und/oder als Schnittstellenprogramm ausgebildet ist, welches die Funktionseinrichtungen (3) in definierter Weise mit Informationen versorgt und insbesondere einen bidirektionalen Informationsaustausch in definierter Form ermöglicht.

7. Sensorsystem nach mindestens einem der Ansprüche 1 bis 6, **dadurch gekennzeichnet, dass** das Sensorsystem zumindest einen Drehratensensor, wenigstens einen Beschleunigungssensor, einen Lenkwinkelsensor und mindestens einen Raddrehzahlsensoren als Sensorelemente (4) aufweist und insbesondere zusätzlich wenigstens einen Chassis-Höhenstandssensor und/oder zumindest einen Umfeldsensor und/oder wenigstens einen optischen Geschwindigkeitssensor und/oder mindestens ein Satellitennavigationssystem zur Positionserfassung.

8. Sensorsystem nach mindestens einem der Ansprüche 1 bis 7, **dadurch gekennzeichnet, dass** die Signalverarbeitungseinrichtung (1) so ausgebildet ist, dass sie bei Detektion einer fehlerhaften oder nicht verfügbaren primären Messgröße oder abgeleiteten Messgröße, eine redundante primäre Messgröße oder abgeleitete Messgröße als Ersatzsignal und/oder Ersatzinformation für wenigstens eine Funktionseinrichtung (3) bereitstellt.

9. Sensorsystem nach mindestens einem der Ansprüche 1 bis 8, **dadurch gekennzeichnet, dass** die Sensorelemente (4) und die Signalverarbeitungseinrichtung (1) und insbesondere zusätzlich die Schnittstelleneinrichtung (2), so ausgebildet und miteinander verbunden sind, dass wenigstens die primären Messgrößen und die abgeleiteten Messgrößen in definierten Zeitintervallen und/oder mit definierten Mindestantwortzeiten den Funktionseinrichtungen (3) bereitgestellt werden.

10. Sensorsystem nach mindestens einem der Ansprüche 1 bis 9, **dadurch gekennzeichnet, dass** wenigstens zwei Sensorelemente (4) einer Sensorelementgruppe direkt miteinander verbunden sind und nur ein erstes dieser Sensorelemente mit der Signalverarbeitungseinrichtung (1) verbunden ist, wobei das erste Sensorelement als Master-Sensorelement in der Kommunikation mit dem wenigstens einen weiteren Sensorelement, als Slave-Sensorelement, dieser Sensorelementgruppe ausgebildet ist.

11. Sensorsystem nach Anspruch 10, **dadurch gekennzeichnet, dass** die Sensorelementgruppe so ausgebildet ist, insbesondere das Master-Sensorelement, dass bereits wenigstens eine primäre Messgröße mit zumindest einer abgeleiteten Messgröße des selben Typs verglichen wird und/oder redundante primäre Messgrößen miteinander verglichen werden, wobei diese Messgrößen insgesamt von mehreren Sensorelementen bereitgestellt werden, wobei das Resultat dieses zumindest einen Messgrößenvergleichs und/oder zumindest eine auf diese Weise plausibilisierte primäre Messgröße und/oder abgeleitete Messgröße der Signalverarbeitungseinrichtung (1) zur Verfügung gestellt werden.

12. Sensorsystem nach mindestens einem der Ansprüche 1 bis 11, **dadurch gekennzeichnet, dass** mehrere, insbesondere sämtliche, der Sensorelemente jeweils eine eigene Signalverarbeitungsschaltung umfassen und diese Sensorelemente miteinander verbunden sind und ein Sensorelementnetzwerk bilden und dass die Sensorelemente dieses Netzwerks wenigstens Messgrößen und/oder abgeleitete Messgrößen zumindest teilweise miteinander austauschen und dass diese Sensorelemente so ausgebildet sind, dass sie zumindest Messgrößen und/oder abgeleitete Messgrößen wenigstens plausibilisieren, wobei das Sensorelementnetzwerk mit der Signalverarbeitungseinrichtung (1) verbunden ist und wobei die Messgrößen und abgeleiteten Messgrößen der Sensorelemente des Sensorelementnetzwerks zumindest teilweise an die Signalverarbeitungseinrichtung (1) übertragen werden.

13. Sensorsystem nach mindestens einem der Ansprüche 10 bis 12, **dadurch gekennzeichnet, dass** die Signalverarbeitungseinrichtung (1) nur einen einzigen Mikroprozessor umfasst und die Signalverarbeitungsfunktionen (5, 6, 7, 8, 9) nur von einem einzigen Mikroprozessor abgearbeitet werden.

## Claims

1. Sensor system comprising a number of sensor elements (4) which are constructed in such a manner that they detect at least partially different primary measured variables and utilize at least partially different measuring principles, furthermore comprising a signal processing facility (1), an interface facility (2) and a number of functional facilities (3), wherein the sensor elements (4) are connected to the signal processing facility (1) which is designed in such a manner that it comprises at least in each case one of the following signal processing functions for at least one of the sensor elements (4) and/or its output signals,
a fault management function (5, 9),
a filtering function (6),
a calculation and/or provision of a derived measured variable (7), wherein at least one measured variable is derived from at least one primary measured variable of one or more sensor elements (4),
and in that
all functional facilities (3) are connected to the signal processing facility (1) via the interface facility (2) and the signal processing facility (1) provides the signal processing functions (5, 6, 7, 8, 9) to the functional facilities (3), **characterized in that** the signal processing facility (1) is constructed in such a manner that it additionally exhibits an information quality evaluation function which provides an information item about the accuracy and the reliability or the accuracy and the availability or the accuracy and the reliability and the availability of one or more or each individual one of the derived and/or primary measured variable/s.

2. Sensor system according to Claim 1, **characterized in that** it is constructed as a part of a motor vehicle control system and **in that** at least one of the functional facilities (3) is constructed as driving dynamics control function and/or motor vehicle safety function and/or motor vehicle passenger comfort function, wherein especially this at least one function is designed at least partially as a program.

3. Sensor system according to Claim 1 or 2, **characterized in that** all sensor elements (4) of this sensor system are connected jointly and/or in each case to the signal processing facility (1).

4. Sensor system according to at least one of Claims 1 to 3, **characterized in that** the signal processing facility (1) is constructed in such a manner that it additionally comprises a calibration function (8) by means of which the calibration of a sensor element (4) and/or its signal processing is performed or started or influenced.

5. Sensor system according to at least one of Claims 1 to 4, **characterized in that** the signal processing facility (1) comprises one or more programs which are processed on at least one microprocessor.

6. Sensor system according to at least one of Claims 1 to 5, **characterized in that** the interface facility (2) is constructed as a bus and/or as an interface program which supplies the functional facilities (3) with information in a defined manner and, in particular, provides for bidirectional information exchange in a defined form.

7. Sensor system according to at least one of Claims 1 to 6, **characterized in that** the sensor system exhibits at least one rate-of-rotation sensor, at least one acceleration sensor, one steering angle sensor and at least one wheel speed sensor as sensor elements (4) and especially additionally at least one chassis level sensor and/or at least one environmental sensor and/or at least one optical speed sensor and/or at least one satellite navigation system for the detection of position.

8. Sensor system according to at least one of Claims 1 to 7, **characterized in that** the signal processing facility (1) is constructed in such a manner that, on detection of a faulty or non-available primary measured variable or derived measured variable, it provides a redundant primary measured variable or derived measured variable as replacement signal and/or replacement information for at least one functional facility (3).

9. Sensor system according to at least one of Claims 1 to 8, **characterized in that** the sensor elements (4) and the signal processing facility (1) and particularly additionally the interface facility (2) are constructed and connected to one another in such a manner that at least the primary measured variables and the derived measured variables are provided to the functional facilities (3) in defined time intervals and/or with defined minimum response times.

10. Sensor system according to at least one of Claims 1 to 9, **characterized in that** at least two sensor elements (4) of a group of sensor elements are connected directly to one another and only a first one of these sensor elements is connected to the signal processing facility (1), wherein the first sensor element is constructed as master sensor element in the communication with the at least one further sensor element, as slave sensor element, of this group of sensor elements.

11. Sensor system according to Claim 10, **characterized in that** the group of sensor elements is constructed in such a manner, especially the master sensor element, that at least one primary measured variable is already compared with at least one derived measured variable of the same type and/or redundant primary measured variables are compared with one another, wherein these measured variables are provided overall by a number of sensor elements, wherein the result of this at least one comparison of measured variables and/or at least one primary measured variable validated in this manner and/or derived measured variable are provided to the signal processing facility (1).

12. Sensor system according to at least one of Claims 1 to 11, **characterized in that** a number, particularly all, of the sensor elements in each case comprise their own signal processing circuit and these sensor elements are connected to one another and form a network of sensor elements and **in that** the sensor elements of this network exchange at least measured variables and/or derived measured variables at least partially with one another and **in that** these sensor elements are constructed in such a manner that they at least validate at least measured variables and/or derived measured variables, wherein the network of sensor elements is connected to the signal processing facility (1) and wherein the measured variables and derived measured variables of the sensor elements of the network of sensor elements are transported at least partially to the signal processing facility (1).

13. Sensor system according to at least one of Claims 10 to 12, **characterized in that** the signal processing facility (1) comprises only a single microprocessor and the signal processing functions (5, 6, 7, 8, 9) are only processed by a single microprocessor.

## Revendications

1. Système de capteurs comprenant plusieurs éléments de capteur (4) configurés de manière à saisir des grandeurs de mesure primaire dont au moins certaines sont différentes et utiliser des principes de mesure dont au moins certains sont différents, le système comprenant en outre
un dispositif (1) de traitement de signaux, un dispositif d'interface (2) ainsi que plusieurs dispositifs fonctionnels (3),
les éléments de capteur (4) étant raccordés au dispositif (1) de traitement de signaux configuré de manière à comporter au moins l'une des fonctions ci-dessous de traitement de signaux pour au moins l'un des éléments de capteur (4) et/ou de ses signaux de sortie :
un traitement (5, 9) des défauts,
un filtrage (6),
la formation d'une grandeur de mesure (7) dérivée, au moins une grandeur de mesure étant dérivée d'au moins une grandeur de mesure primaire d'un ou de plusieurs éléments de capteur (4),
tous les dispositifs fonctionnels (3) étant reliés par le dispositif d'interface (2) au dispositif (1) de traitement de signaux et
le dispositif (1) de traitement de signaux délivrant les fonctions (5, 6, 7, 8, 9) de traitement de signaux aux dispositifs fonctionnels (3), **caractérisé en ce que**
le dispositif (1) de traitement de signaux est configuré de manière à présenter en outre une fonction d'évaluation de la qualité des informations qui délivre une information concernant la précision et la fiabilité, la précision et la disponibilité ou la précision, la fiabilité et la disponibilité d'une ou plusieurs des grandeurs de mesure dérivées et/ou primaires ou de chacune de ces dernières.

2. Système de capteurs selon la revendication 1, **caractérisé en ce qu'**il est configuré comme système de régulation pour véhicule automobile et **en ce qu'**au moins l'un des dispositifs fonctionnels (3) est configuré comme fonction de régulation de la dynamique de roulage, comme fonction de sécurité du véhicule automobile et/ou comme fonction de confort des passagers du véhicule automobile, cette ou ces fonctions étant au moins en partie configurées en tant que programmes.

3. Système de capteurs selon les revendications 1 ou 2, **caractérisé en ce que** tous les éléments de capteur (4) de ce système de capteurs sont raccordés ensemble et/ou séparément au dispositif (1) de traitement de signaux.

4. Système de capteurs selon au moins l'une des revendications 1 à 3, **caractérisé en ce que** le dispositif (1) de traitement de signaux est configuré de manière à comporter en outre une fonction d'étalonnage (8) par laquelle l'étalonnage d'un élément de capteur (4) et/ou du traitement de ces signaux peut être exécuté, lancé ou modifié.

5. Système de capteurs selon au moins l'une des revendications 1 à 4, **caractérisé en ce que** le dispositif (1) de traitement de signaux comporte un ou plusieurs programmes qui sont exécutés sur au moins un microprocesseur.

6. Système de capteurs selon au moins l'une des revendications 1 à 5, **caractérisé en ce que** le dispositif d'interface (2) est configuré comme bus et/ou comme programme d'interface qui alimentent en informations les dispositifs fonctionnels (3) de manière définie et qui permettent en particulier un échange bidirectionnel d'informations sous une forme définie.

7. Système de capteurs selon au moins l'une des revendications 1 à 6, **caractérisé en ce que** le système de capteurs présente comme éléments de capteur (4) au moins un capteur de vitesse de rotation, au moins un capteur d'accélération, un capteur d'angle de braquage et au moins un capteur de vitesse de rotation des roues et en outre notamment au moins un capteur de niveau du châssis, au moins un capteur d'environnement, au moins un capteur optique de vitesse et/ou au moins un système de navigation par satellite permettant de déterminer la position.

8. Système de capteurs selon au moins l'une des revendications 1 à 7, **caractérisé en ce que** le dispositif (1) de traitement de signaux est configuré de telle sorte que lorsqu'il détecte qu'une grandeur de mesure primaire ou une grandeur de mesure dérivée sont erronées ou ne sont pas disponibles, délivre une grandeur de mesure primaire ou une grandeur de mesure dérivée redondantes comme signal de remplacement et/ou comme information de remplacement pour au moins un dispositif fonctionnel (3).

9. Système de capteurs selon au moins l'une des revendications 1 à 8, **caractérisé en ce que** les éléments de capteur (4) et le dispositif (1) de traitement de signaux et en outre notamment le dispositif d'interface (2) sont configurés et raccordés les uns aux autres de telle sorte qu'au moins les grandeurs de mesure primaires et les grandeurs de mesure dérivées soient délivrées aux dispositifs fonctionnels (3) à des intervalles de temps définis et/ou à des temps de réponse minimums définis.

10. Système de capteurs selon au moins l'une des revendications 1 à 9, **caractérisé en ce qu'**au moins deux éléments de capteur (4) d'un groupe d'éléments de capteur sont raccordés directement l'un à l'autre et **en ce que** seul un premier de ces éléments de capteur est raccordé au dispositif (1) de traitement de signaux, le premier élément de capteur étant configuré comme élément de capteur-maître dans la communication, le ou les autres éléments de capteur formant des éléments de capteur esclaves de ce groupe d'éléments de capteur.

11. Système de capteurs selon la revendication 10, **caractérisé en ce que** le groupe d'éléments de capteur et en particulier l'élément de capteur-maître sont configurés de telle sorte qu'au moins une grandeur primaire de mesure est comparée à au moins une grandeur de mesure dérivée du même type, **en ce que** des grandeurs de mesure primaires redondantes délivrées globalement par plusieurs éléments de capteur sont comparées les unes aux autres, le résultat de cette ou de ces comparaisons de grandeurs de mesure et/ou au moins l'une des grandeurs de mesure primaires et/ou des grandeurs de mesure dérivées ainsi plausibilisées étant apportées au dispositif (1) de traitement de signaux.

12. Système de capteurs selon au moins l'une des revendications 1 à 11, **caractérisé en ce que** plusieurs et en particulier tous les éléments de capteur comportent chacun leur propre circuit de traitement de signaux, ces éléments de capteur étant raccordés les uns aux autres et formant un réseau d'éléments de capteur, **en ce qu'**au moins certains des éléments de capteur de ce réseau échangent au moins des grandeurs de mesure et/ou des grandeurs de mesure dérivées, **en ce que** ces éléments de capteur sont configurés de telle sorte qu'ils plausibilisent au moins des grandeurs de mesure et/ou des grandeurs de mesure dérivées, **en ce que** le réseau d'éléments de capteur est raccordé au dispositif (1) de traitement de signaux et **en ce qu'**au moins certaines des grandeurs de mesure et des grandeurs de mesure dérivées des éléments de capteur sont transmises au dispositif (1) de traitement de signaux.

13. Système de capteurs selon au moins l'une des revendications 10 à 12, **caractérisé en ce que** le dispositif (1) de traitement de signaux ne comporte qu'un seul microprocesseur et **en ce que** les fonctions (5, 6, 7, 8, 9) de traitement de signaux ne sont traitées que par un seul microprocesseur.
